# FASCICULE DE BREVET EUROPEEN

(11) **EP 3 280 020 B1**
(45) Date de publication et mention de la délivrance du brevet: **30.11.2022**
(21) Numéro de dépôt: 17156589.8
(22) Date de dépôt: 17.02.2017
(51) Int. Cl.: H02H 9/04, H02H 7/125, G06K 19/07, G06K 19/077

(54) **CIRCUIT ET PROCÉDÉ DE PROTECTION DE MOYENS DE RÉGULATION DE TENSION CONTRE LES DÉCHARGES ÉLECTROSTATIQUES**
SCHALTKREIS UND VERFAHREN ZUM SCHUTZ DER SPANNUNGSREGULIERUNGSMITTEL GEGEN ELEKTROSTATISCHE ENTLADUNGEN
CIRCUIT AND METHOD FOR PROTECTING VOLTAGE REGULATION MEANS AGAINST ELECTROSTATIC DISCHARGES

(30) Priorité: 04.08.2016 FR 1657569
(43) Date de publication de la demande: 07.02.2018
(73) Titulaire: STMicroelectronics (Rousset) SAS, 13790 Rousset (FR)
(72) Inventeur: DEMANGE, Nicolas, 83470 Saint-Maximin (FR)
(74) Mandataire: Casalonga

(56) Documents cités:
- WO-A1-2007/046015
- FR-A1- 2 982 416
- FR-A1- 2 987 496
- US-A1- 2007 109 697
- US-A1- 2013 258 533

## Description

Des modes de mise en œuvre et de réalisation de l'invention concernent les dispositifs électroniques, et notamment les dispositifs électroniques destinés à la protection de composants contre les décharges électrostatiques (ESD : Electrostatic Discharge en langue anglaise).

Dans le domaine de la microélectronique, une décharge électrostatique peut se produire tout au long de la vie d'un circuit intégré, et constitue un vrai problème pour la fiabilité de ce circuit intégré, ainsi qu'une cause majeure de défaillance.

En particulier, une décharge électrostatique peut survenir durant l'étape de fabrication d'un circuit, lorsqu'une personne chargée d'électricité statique manipule le circuit. Au contact des composants, l'électricité statique se décharge du corps de la personne dans le circuit intégré et peut l'endommager.

Une décharge électrostatique se traduit généralement par un pic de courant plus ou moins important et plus ou moins court.

Certains types de circuit intégré, comme par exemple les circuits intégrés radiofréquence comportant une antenne, comportent des dispositifs de régulation couplés aux bornes de l'antenne permettant de limiter les éventuelles surtensions pouvant apparaître lors du fonctionnement normal du circuit. Classiquement, ces circuits de régulation comportent plusieurs transistors qui deviennent passants lorsque la tension aux bornes de l'antenne dépasse un certain seuil. Ainsi, l'impédance aux bornes de l'antenne est modifiée, la surtension est absorbée.

Cependant, il est nécessaire que ces transistors restent bloqués lors de l'apparition d'une décharge électrostatique, car les courants générés sont trop importants pour pouvoir traverser les transistors sans les endommager.

L'utilisation de plusieurs transistors permet notamment de pouvoir bloquer l'un ou l'autre des transistors en fonction de la borne qui reçoit une décharge électrostatique, ce qui permet une protection symétrique du dispositif.

Exemples de dispositifs de protection selon l'art antérieur sont divulgués par les documents US 2013/258533, FR 2982416, et WO 2007/046015.

Cependant, l'utilisation de plusieurs transistors présente un inconvénient du point de vue de l'encombrement surfacique. Il est donc proposé ici de réduire cet encombrement.

Selon la présente invention, qui est définie par le jeux des revendications ici-joint, il est proposé un circuit intégré comprenant une première borne et une deuxième borne, des moyens de traitement connectés entre les deux bornes, des moyens de régulation de tension configurés pour réguler la tension entre les deux bornes, des moyens de protection configurés pour protéger les moyens de traitement lors de l'apparition d'une décharge électrostatique alors que le circuit intégré n'est pas alimenté et des moyens de commande configurés pour rendre inactif les moyens de régulation lors de l'apparition d'une décharge électrostatique alors que le circuit intégré n'est pas alimenté.

Selon une caractéristique générale de cet aspect, les moyens de régulation comportent un seul transistor ou un groupe de plusieurs transistors en parallèle, connecté entre les deux bornes.

Par ailleurs les moyens de commande sont configurés pour rendre les moyens de régulation inactifs lors de l'apparition d'une décharge électrostatique quel que soit le sens de circulation de l'impulsion entre les deux bornes résultant de ladite décharge électrostatique.

En d'autres termes, il est proposé ici un circuit comportant un encombrement surfacique réduit et dont les moyens de régulation sont protégés de manière symétrique contre les décharges électrostatiques.

Selon un mode de réalisation, les moyens de commande sont couplés à la grille du transistor de régulation et sont configurés pour coupler la grille du transistor de régulation à la deuxième borne lors de l'apparition d'une décharge électrostatique circulant de la première borne vers la deuxième borne, et pour coupler la grille du transistor de régulation à la première borne lors de l'apparition d'une décharge électrostatique circulant de la deuxième borne vers la première borne.

On connecte donc la grille du transistor de régulation à la borne du circuit qui ne reçoit pas la décharge électrostatique, et qui fait donc office de tension de référence, ou masse équivalente, ce qui a pour effet de bloquer le transistor de régulation.

Les moyens de protection comportent un circuit de protection et un circuit de déclenchement capable de déclencher le circuit de protection en présence d'une décharge électrostatique, et les moyens de commande comportent un premier transistor, un deuxième transistor, un troisième transistor, et un quatrième transistor, les quatre transistors étant montés en série entre la première et la deuxième borne, le premier transistor ayant sa grille couplée à la deuxième borne et l'une de ses électrodes couplée à la première borne, le deuxième transistor et le troisième transistor ayant leurs grilles respectives couplées au circuit de déclenchement et chacun une électrode couplée à la grille du transistor de régulation, et le quatrième transistor ayant sa grille couplée à la première borne et l'une de ses électrode couplée à la deuxième borne.

Le circuit intégré CI peut également comprendre des moyens de comparaison configurés pour activer les moyens de régulation en présence d'une surtension et une résistance peut être montée en série entre les moyens de comparaison et la grille du ou des transistors de régulation. Cela permet d'améliorer encore d'avantage l'efficacité des moyens de commande.

Selon un deuxième aspect, il est proposé un dispositif sans contact comportant un circuit intégré tel que décrit précédemment et une antenne connectée à la première borne et à la deuxième borne.

Le dispositif peut être une carte à puce, un badge d'identification, ou être intégré à un appareil de communication sans fil, par exemple un téléphone mobile cellulaire ou une tablette.

D'autres avantages et caractéristiques de l'invention apparaîtront à l'examen de la description détaillée de modes de mise en œuvre et de réalisation, nullement limitatifs, et des dessins annexés sur lesquels :

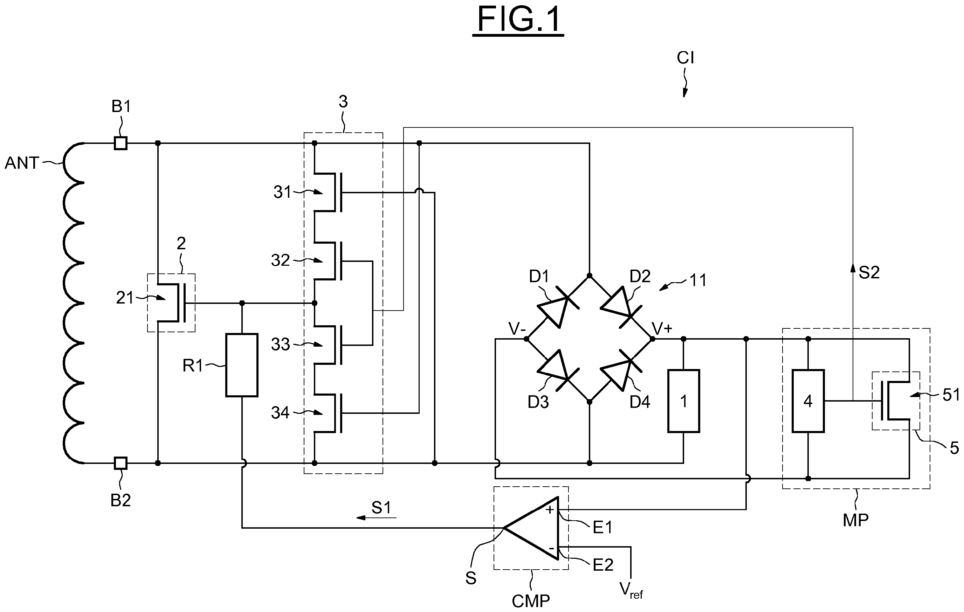

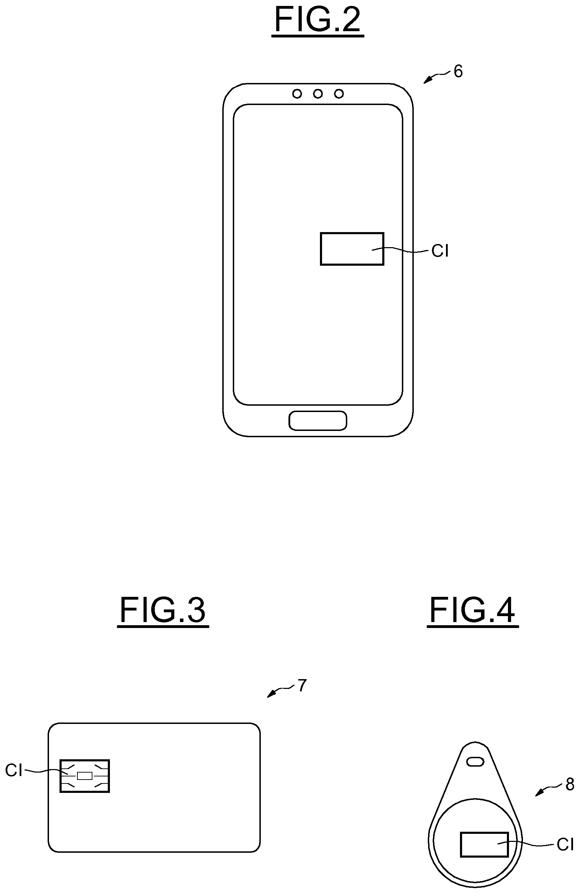

- Les figures 1 à 4 illustrent des modes de réalisation de l'invention.

La figure 1 illustre schématiquement un exemple de circuit intégré CI selon l'invention d'un point de vue électrique.

Le circuit CI est ici un circuit de radio-identification (« RFID », Radio Frequency Identification selon l'acronyme anglo-saxon bien connu de l'homme du métier) couplé à une antenne ANT configurée pour capter des signaux électromagnétiques extérieurs et pour les convertir par induction en signaux électriques.

L'antenne ANT est connectée au circuit CI par l'intermédiaire d'une première borne B1 et d'une deuxième borne B2.

Le circuit intégré CI comporte notamment un pont de Graetz 11 comportant classiquement une première diode D1, une deuxième diode D2, une troisième diode D3 et une quatrième diode D4 montées en pont. Le pont de Graetz est classiquement configuré pour redresser le courant alternatif induit dans l'antenne.

Les cathodes de la deuxième diode D2 et de la quatrième diode D4 sont couplées à une première borne de pont V+, et les anodes de la première diode D2 et de la troisième diode D3 sont couplées à une deuxième borne de pont V-. Ici, la deuxième borne de pont V- est une masse flottante pour le circuit intégré CI en fonctionnement.

Des moyens de traitement 1 configurés pour traiter les signaux captés par l'antenne sont connectés entre la première borne de pont V+ et la deuxième borne B2. Les moyens de traitement 1 comportent classiquement des composants tels que des circuits logiques et/ou un microcontrôleur.

Lorsque le circuit intégré CI est en fonctionnement, il est possible que l'antenne ANT soit soumise à des champs électromagnétiques particulièrement intenses, pouvant générer dans l'antenne ANT des courants électriques, ou surintensités, susceptibles d'endommager les moyens de traitements 1.

Ainsi, afin de limiter les effets de ces surintensités, le circuit intégré CI comporte des moyens de régulation 2 couplés entre les deux bornes d'antenne B1 et B2. Ici, les moyens de régulation 2 comprennent avantageusement un unique transistor de régulation 21, ici un transistor NMOS.

Il convient de noter que la figure 1 illustre ici le transistor de régulation 21 de façon schématique. En pratique, le transistor de régulation 21 peut comprendre un groupe de plusieurs transistors couplés en parallèle.

Des moyens de comparaison CMP sont ici couplés entre la grille du transistor de régulation 21 et la première borne de pont V+. Les moyens de comparaison CMP sont configurés pour comparer le potentiel électrique sur la première borne de pont V+ à un potentiel de référence V_{ref}, et si le potentiel sur la première borne de pont V+ dépasse la valeur du potentiel de référence, pour envoyer un premier signal de commande S1 sur la grille du transistor de régulation 21 afin de le mettre dans un état passant. Ici, les moyens de comparaison sont réalisés par un comparateur CMOS comportant classiquement une première entrée E1 connectée à la première borne de pont V+, une deuxième entrée E2 configurée pour recevoir le potentiel de référence V_{ref}, et une sortie S connectée à la grille du transistor de régulation 21.

Ainsi, l'impédance aux bornes de l'antenne ANT augmente, ce qui a pour effet de diminuer la tension entre les bornes B1 et B2. Les composants des moyens de traitement 1 sont donc protégés des surtensions.

Lorsque le circuit intégré CI est hors fonctionnement, typiquement pendant la phase de fabrication, il est possible qu'il soit manipulé par des opérateurs chargés d'électricité statique, provoquant une décharge électrostatique au contact par exemple de l'antenne ANT.

Dans ce cas, la décharge électrostatique se traduit par une impulsion de courant particulièrement forte circulant entre les bornes B1 et B2.

On peut parler par exemple de décharge positive lorsque la décharge a lieu de la première borne B1 vers la deuxième borne B2 (dans ce cas la deuxième borne B2 fait office de masse équivalente pour le circuit CI), et de décharge négative lorsque la décharge a lieu de la deuxième borne B2 vers la première borne B1 (dans ce cas la première borne B1 fait office de masse équivalente pour le circuit CI).

Une décharge électrostatique se distingue d'une surintensité classique par la durée plus courte de l'événement, et par l'intensité plus importante du courant généré.

Il est donc nécessaire d'une part de maintenir le transistor de régulation 21 dans un état bloqué afin d'éviter qu'il soit endommagé par l'impulsion de courant induit, et d'autre part de dévier le courant induit par la décharge électrostatique afin qu'il ne traverse pas les moyens de traitement 1.

Pour cela, le circuit intégré CI comporte des moyens de commande 3, et des moyens de protection MP comportant un circuit de déclenchement 4 et un circuit de protection 5.

Le circuit de déclenchement 4 est configuré pour détecter l'apparition d'une décharge électrostatique quel que soit son sens de circulation entre les deux bornes B1 et B2, et le cas échéant pour envoyer un deuxième signal de commande S2 aux moyens de commande 3 et au circuit de protection 5. Le circuit de déclenchement 4 peut comprendre classiquement un circuit résistif capacitif.

Le circuit de protection 5 comprend ici un transistor de protection 51 couplé entre la première borne de pont V+ et la deuxième borne de pont V-, et dont la grille est couplée au circuit de déclenchement 4. Il serait également envisageable d'avoir un circuit de protection 5 comprenant des thyristors.

Il convient de noter qu'en pratique, le transistor de protection 51 peut être un groupe d'une pluralité de transistor couplés en parallèle, et que la taille du transistor de protection 51 est très supérieure à la taille du transistor de régulation 21. Par exemple, le transistor de régulation 21 possède des dimensions de l'ordre de la centaine de micromètres, tandis que les dimensions du transistor de protection 51 sont de l'ordre du millimètre. La taille plus importante du transistor de protection 51 lui permet de supporter des courants de forte intensité, par exemple générés par une décharge électrostatique.

Le transistor de protection 51 est configuré pour passer dans un état passant lors de la réception du deuxième signal de commande S2.

Ainsi, une décharge électrostatique sur l'une des bornes B1 ou B2, transmise à la première borne de pont V+ par l'intermédiaire de la deuxième diode D2 ou de la quatrième diode D4, sera transmise à la deuxième borne de pont V- via le transistor de protection 51 et ne circulera donc pas dans les composants de traitements 12.

Les moyens de commande 3 sont configurés pour coupler la grille du transistor de régulation 21 à la deuxième borne B2 lors de l'apparition d'une décharge électrostatique sur la première borne B1, et pour coupler la grille du transistor de régulation 21 à la première borne B1 lors de l'apparition d'une décharge électrostatique sur la deuxième borne B2.

Les moyens de commande 3 comportent ici un premier transistor NMOS 31, un deuxième transistor NMOS 32, un troisième transistor NMOS 33, et un quatrième transistor NMOS 34, montés en série entre la première borne B1 et la deuxième borne B2.

Le premier transistor NMOS 31 est monté entre la première borne B1 et le deuxième transistor 32, le quatrième transistor 34 est couplé entre le troisième transistor 33 et la deuxième borne B2, et le deuxième transistor NMOS 32 et le troisième transistor NMOS 33 sont mutuellement couplés par l'une de leurs électrodes.

La grille du premier transistor NMOS 31 est couplée à la deuxième borne B2, et la grille du quatrième transistor est couplée à la première borne B1.

Les grilles du deuxième transistor NMOS 32 et du troisième transistor NMOS 33 sont mutuellement couplées et connectées au circuit de déclenchement 4 de façon à être aptes à recevoir le deuxième signal de commande S2.

Les électrodes mutuellement couplées du deuxième transistor NMOS 32 et du troisième transistor NMOS 33 sont couplées à la grille du transistor de régulation 21.

Lors de l'apparition d'une décharge électrostatique positive, c'est-à-dire ici circulant de la première borne B1 vers la deuxième borne B2, le circuit de déclenchement 4 envoie le deuxième signal de commande S2 sur la grille du deuxième transistor NMOS 32, sur la grille du troisième transistor NMOS 33 et sur la grille du transistor de protection 51.

En réponse au deuxième signal de commande S2, les deuxième et troisième transistors 32 et 33 passent à l'état passant, et en raison du fort potentiel sur la première borne B1 dû à la décharge électrostatique, le quatrième transistor NMOS 34 passe à l'état passant.

Le premier transistor NMOS 31 a sa grille connectée à la deuxième borne B2, qui fait ici office de masse équivalente, et reste donc bloqué.

La grille du transistor de régulation 21 se retrouve donc couplée à la deuxième borne B2 par l'intermédiaire du troisième transistor NMOS 33 et du quatrième transistor NMOS 34, et est donc connectée à la masse équivalente du circuit. Le transistor de régulation 21 est donc dans un état bloqué.

Dans le cas où la décharge électrostatique est négative, c'est-à-dire ici circulant de la deuxième borne B2 vers la première borne B1, le premier transistor NMOS 31 est à l'état passant et le quatrième transistor NMOS 34 reste bloqué. La grille du transistor de régulation 21 est donc connectée à la première borne B1, qui fait dans ce cas office de masse équivalente. Le transistor de régulation 21 est donc également bloqué.

Ainsi, l'utilisation de quatre transistors est ici particulièrement avantageuse. En effet, le premier transistor NMOS 31 et le quatrième transistor NMOS 34 permettent de sélectionner la borne à laquelle connecter la grille du transistor de régulation 21, tandis que le deuxième transistor NMOS 32 et le troisième transistor NMOS 33, couplés au circuit de déclenchement 4, permettent d'assurer l'activation des moyens de commande 3 uniquement lors d'une décharge électrostatique.

Plus précisément, lorsque le circuit intégré CI est en fonctionnement, la première borne B1 peut se trouver à un potentiel non nul. Dans ce cas, le quatrième transistor 34 devient passant. De même, la deuxième borne B2 peut se trouver à un potentiel non nul et dans ce cas le premier transistor 31 devient passant.

Cependant, si le potentiel sur la première borne B1 ou sur la deuxième borne B2 ne résulte pas d'une décharge électrostatique, c'est-à-dire s'il ne correspond pas à une impulsion et n'a pas une valeur particulièrement élevée, alors le circuit de déclenchement 4 n'envoie pas le deuxième signal de commande S2 sur les grilles du deuxième transistor 32 et du troisième transistor 33 qui restent dans un état bloqué.

Ainsi en l'absence de décharge électrostatique, la grille du transistor de régulation ne peut pas être connectée à l'une ou l'autre des bornes B1 et B2, les moyens de commande 3 ne peuvent donc pas être activés.

Une résistance R1 a en outre avantageusement été couplée entre les moyens de comparaison CMP et la grille du transistor de régulation 21 afin d'améliorer encore davantage l'efficacité des moyens de commande 3. En effet, lors d'une décharge électrostatique, il est possible que des courants parasites soient générés en sortie des moyens de comparaison CMP. La résistance permet de limiter ces courants et donc de s'assurer que la grille du transistor de régulation 21 soit bien à un potentiel nul lorsque le circuit de commande 3 est activé.

Le circuit électronique CI tel que décrit précédemment et illustré par la figure 1 peut être incorporé au sein de systèmes électroniques tels que des badges de radio-identification, des cartes de paiement, des téléphones portables intelligents, etc.

Les figures 2 à 4 illustrent des systèmes comportant un circuit électronique tel que décrit précédemment et illustré sur la figure 1.

La figure 2 illustre un téléphone portable intelligent 6 (« Smartphone », selon la dénomination anglo-saxonne bien connue de l'homme du métier) comportant un circuit intégré CI de radio identification tel que décrit précédemment.

La figure 3 illustre une carte à puce 7 permettant les paiements dits « sans contact », ladite carte à puce comportant un circuit intégré CI tel que décrit précédemment.

La figure 4 illustre un badge de radio-identification 8, classiquement configuré pour permettre l'accès à des locaux sécurisés en passant ledit badge à proximité d'un dispositif de lecture (non représenté). Le badge de radio-identification 8 comporte un circuit électronique CI tel que décrit précédemment.

## Revendications

1. Circuit intégré comprenant une première borne (B1) et une deuxième borne (B2), des moyens de traitement (1) connectés entre les deux bornes (B1, B2), des moyens de régulation de tension (2) configurés pour réguler la tension entre les deux bornes (B1, B2), des moyens de protection (MP) configurés pour protéger les moyens de traitement (1) lors de l'apparition d'une décharge électrostatique alors que le circuit intégré n'est pas alimenté et des moyens de commande (3) configurés pour rendre inactifs les moyens de régulation (2) lors de l'apparition d'une décharge électrostatique alors que le circuit intégré n'est pas alimenté, dans lequel les moyens de régulation (2) comportent un seul transistor (21) ou un groupe de plusieurs transistors en parallèle, connecté entre les deux bornes (B1, B2) et les moyens de commande (3) sont configurés pour rendre les moyens de régulation (2) inactifs lors de l'apparition d'une décharge électrostatique quel que soit le sens de circulation de l'impulsion entre les deux bornes (B1, B2) résultant de ladite décharge électrostatique, **caractérisé en ce que** les moyens de protection (MP) comportent un circuit de protection (5) et un circuit de déclenchement (4) capable de déclencher le circuit de protection (5) en présence d'une décharge électrostatique et les moyens de commande (3) comportent un premier transistor (31), un deuxième transistor (32), un troisième transistor (33), et un quatrième transistor (34), les quatre transistors étant montés en série entre la première et la deuxième borne (B1, B2), le premier transistor (31) ayant sa grille couplée à la deuxième borne (B2) et l'une de ses électrodes couplée à la première borne (B1), le deuxième transistor et le troisième transistor (32, 33) ayant leurs grilles respectives couplées au circuit de déclenchement (4) et chacun une électrode couplée à la grille du transistor de régulation (2), et le quatrième transistor (34) ayant sa grille couplée à la première borne (B1) et l'une de ses électrode couplée à la deuxième borne (B2).

2. Circuit selon la revendication 1, dans lequel les moyens de commande (3) sont couplés à la grille du transistor de régulation (2) et sont configurés pour coupler la grille du transistor de régulation (2) à la deuxième borne (B2) lors de l'apparition d'une décharge électrostatique circulant de la première borne (B1) vers la deuxième borne (B2), et à la première borne (B1) lors de l'apparition d'une décharge électrostatique circulant de la deuxième borne (B2) vers la première borne (B1).

3. Circuit selon l'une des revendications 1 ou 2, comprenant en outre des moyens de comparaison configurés pour activer les moyens de régulation en présence d'une surtension et une résistance couplée en série entre les moyens de comparaison (CMP) et la grille du ou des transistors de régulation (2).

4. Dispositif comportant un circuit selon l'une des revendications 1 à 3 et une antenne (ANT) connectée à la première borne (B1) et à la deuxième borne (B2).

5. Dispositif selon la revendication 4, le dispositif formant une carte à puce, un badge de radio-identification ou étant incorporé à un appareil de communication sans fil.

## Patentansprüche

1. Integrierter Schaltkreis, umfassend eine erste Klemme (B1) und eine zweite Klemme (B2), Verarbeitungsmittel (1), die zwischen den zwei Klemmen (B1, B2) verbunden sind, Spannungsregelungsmittel (2), die ausgelegt sind, um die Spannung zwischen den zwei Klemmen (B1, B2) zu regeln, Schutzmittel (MP), die ausgelegt sind, um die Verarbeitungsmittel (1) beim Auftreten einer elektrostatischen Entladung zu schützen, während der integrierte Schaltkreis nicht versorgt ist und Steuermittel (3), die ausgelegt sind, um die Regelungsmittel (2) beim Auftreten einer elektrostatischen Entladung zu deaktivieren, während der integrierte Schaltkreis nicht versorgt ist, wobei die Regelungsmittel (2) einen einzigen Transistor (21) oder eine Gruppe aus mehreren parallelen Transistoren, verbunden zwischen den zwei Klemmen (B1, B2), aufweisen und die Steuermittel (3) ausgelegt sind, um die Regelungsmittel (2) während des Auftretens einer elektrostatischen Entladung zu deaktivieren, unabhängig von der Zirkulationsrichtung des Impulses zwischen den zwei Klemmen (B1, B2) im Ergebnis der elektrostatischen Entladung,
**dadurch gekennzeichnet, dass** die Schutzmittel (MP) einen Schutzschaltkreis (5) und einen Triggerschaltkreis (4) aufweisen, der imstand ist, den Schutzschaltkreis (5) bei Anwesenheit einer elektrostatischen Entladung auszulösen und die Steuermittel (3) einen ersten Transistor (31), einen zweiten Transistor (32), einen dritten Transistor (33) und einen vierten Transistor (34) aufweisen, wobei die vier Transistoren in Reihen zwischen der ersten und der zweiten Klemme (B1, B2) angebracht sind, wobei das Gitter des ersten Transistors (31) mit der zweiten Klemme (B2) gekoppelt ist und eine seiner Elektroden mit der ersten Klemme (B1) gekoppelt ist, wobei das Gitter des zweiten Transistors und des dritten Transistors (32, 33) jeweils mit dem Triggerschaltkreis (4) gekoppelt ist und jeweils eine Elektrode mit dem Gitter des Regelungstransistors (2) gekoppelt ist, und das Gitter des vierten Transistors (34) mit der ersten Klemme (B1) gekoppelt ist und eine seiner Elektroden mit der zweiten Klemme (B2) gekoppelt ist.

2. Schaltkreis nach Anspruch 1, wobei die Steuermittel (3) mit dem Gitter des Regelungstransistors (2) gekoppelt sind und ausgelegt sind, um das Gitter des Regelungstransistors (2) mit der zweiten Klemme (B2) beim Auftreten einer elektrostatischen Entladung zu koppeln, die von der ersten Klemme (B1) zur zweiten Klemme (B2) zirkuliert, und mit der ersten Klemme (B1) beim Auftreten einer elektrostatischen Entladung, die von der zweiten Klemme (B2) zur ersten Klemme (B1) zirkuliert.

3. Schaltkreis nach einem der Ansprüche 1 oder 2, umfassend ferner Vergleichsmittel, die ausgelegt sind, um die Regelungsmittel bei Anwesenheit einer Überspannung zu aktivieren und einen Widerstand, der in Reihe zwischen den Vergleichsmitteln (CMP) und dem Gitter des oder der Regelungstransistoren (2) gekoppelt ist.

4. Vorrichtung, aufweisend einen Schaltkreis nach einem der Ansprüche 1 bis 3 und eine Antenne (ANT), die mit der ersten Klemme (B1) und mit der zweiten Klemme (B2) verbunden ist.

5. Vorrichtung nach Anspruch 4, wobei die Vorrichtung eine Chipkarte, einen Funkidentifikationsbutton bildet oder in ein drahtloses Kommunikationsgerät eingebunden ist.

## Claims

1. An integrated circuit comprising a first terminal (B1) and a second terminal (B2), processing means (1) connected between the two terminals (B1, B2), voltage regulation means (2) configured to regulate the voltage between the two terminals (B1, B2), protection means (MP) configured to protect the processing means (1) upon the appearance of an electrostatic discharge while the integrated circuit is not power supplied and control means (3) configured to inactivate the regulation means (2) when an electrostatic discharge appears while the integrated circuit is not power supplied, wherein the regulation means (2) include a single transistor (21) or a group of several transistors in parallel, connected between the two terminals (B1, B2) and the control means (3) are configured to inactivate the regulation means (2) upon the appearance of an electrostatic discharge regardless of the direction of circulation of the pulse between the two terminals (B1, B2) resulting from said electrostatic discharge, **characterised in that** the protection means (MP) include a protection circuit (5) and a trigger circuit (4) capable of triggering the protection circuit (5) in the presence of an electrostatic discharge and the control means (3) include a first transistor (31), a second transistor (32), a third transistor (33), and a fourth transistor (34), the four transistors being connected in series between the first and the second terminal (B1, B2), the first transistor (31) having its gate coupled to the second terminal (B2) and one of its electrodes coupled to the first terminal (B1), the second transistor and the third transistor (32, 33) having their respective gates coupled to the trigger circuit (4) and each an electrode coupled to the gate of the regulating transistor (2), and the fourth transistor (34) having its gate coupled to the first terminal (B1) and one of its electrodes coupled to the second terminal (B2).

2. The circuit according to claim 1, wherein the control means (3) are coupled to the gate of the regulating transistor (2) and are configured to couple the gate of the regulating transistor (2) to the second terminal (B2) upon the appearance of an electrostatic discharge flowing from the first terminal (B1) to the second terminal (B2), and to the first terminal (B1) upon the appearance of an electrostatic discharge flowing from the second terminal (B2) to the first terminal (B1).

3. The circuit according to one of claims 1 or 2, further comprising comparison means configured to activate the regulation means in the presence of an overvoltage and a resistor coupled in series between the comparison means (CMP) and the gate of the regulating transistor(s) (2).

4. A device including a circuit according to one of claims 1 to 3 and an antenna (ANT) connected to the first terminal (B1) and to the second terminal (B2).

5. The device according to claim 4, the device forming an integrated circuit card, a radio-identification badge or being incorporated into a wireless communication device.
